# EUROPÄISCHE PATENTANMELDUNG

(11) **EP 0 949 582 A1**
(43) Veröffentlichungstag der Anmeldung: **13.10.1999**
(21) Anmeldenummer: 98810884.1
(22) Anmeldetag: 04.09.1998
(51) Int. Cl.: G06K 19/077

(54) **Elektronikobjekt**

(30) Priorität: 07.04.1998 CH 1998820
(71) Anmelder: ESEC Management SA, 6330 Cham (CH); Sempac SA, 6330 Cham (CH)
(72) Erfinder: Ragg, Wolfram, 6332 Hagendorn (CH); Sacher, Dieter, 5400 Baden (CH)

(57) **Zusammenfassung**

Das Elektronikobjekt (**10**) umfasst in einer ersten Ausführung eine Strukturfolie (**14**) zur Aufnahme eines Elektronikelementes und einen Objektkörper (**12**) aus gespritzten Kunststoff. Die Strukturfolie (**14**) besitzt einen Aussenkontakt (**16**), der in einer Aussenfläche des Elektronikobjektes (**10**) liegt und über mindestens eine Abbiegung (**19**) mit dem Rest der Strukturfolie (**14**) verbunden ist; sie weist im Bereich dieser Abbiegung (**19**) an ihrer äusseren Fläche (**17**) eine rückspringende Stufe (**30**) auf, deren Stufenoberkante (**31**) eine Grenze zwischen dem Kunststoff und dem Aussenkontakt (**16**) bildet. Das Elektronikobjekt (**10**) umfasst in einer zweiten Ausführung eine Strukturfolie (**14**) mit einem Elektronikelement (**40**). Dieses ist von einer Kunststoffkapsel (**44**) umgeben, wobei der Kunststoff für die Kunststoffkapsel fliessfähig zugebracht wurde. Die Kunststoffkapsel befindet sich auf einer Fläche der Strukturfolie (**14**), die durch eine Erhöhung begrenzt ist. Diese Erhöhung ist eine in der Strukturfolie (**14**) gebildete Stufe (**30**), welche eine Vertiefung (**34**) der Strukturfolie (**14**) umgibt.

## Beschreibung

Die Erfindung betrifft ein Elektronikobjekt nach dem Oberbegriff des Patentanspruchs **1** bzw. **9**.

Unter Elektronikobjekten im Sinne der Erfindung sollen Gegenstände verstanden werden, die mindestens ein Elektronikelement aufweisen, das in einem Objektkörper eingebettet ist. Bei diesen Elektronikobjekten kann es sich um dünne, flache Gegenstände in der Art von Chipkarten oder um voluminösere Gegenstände in der Art von Anhängern, also sogenannten 'tags', um Spielzeuge oder Fernmeldegeräte, handeln. Das Elektronikelement kann beispielsweise ein Halbleiterchip, ein Ferritkern, ein Kondensator oder ein Widerstand sein, und es kann an einer im Objektkörper angeordneten Strukturfolie aus Kunststoff oder Metall fixiert sein oder strukturfolienfrei unmittelbar im Objektkörper aufgenommen sein. Der Objektkörper besteht aus Kunststoff, der um bzw. an die Strukturfolie gespritzt ist. Die Strukturfolie befindet sich im wesentlichen innerhalb des Objektkörpers, weist aber Aussenkontakte auf, die bündig mit einer Aussenfläche des Elektronikelementes liegen. Die Aussenkontakte werden durch entsprechende Bereiche der Strukturfolie gebildet, die im allgemeinen galvanisch behandelt sind, und die aus der Ebene, in welcher die Strukturfolie im wesentlichen angeordnet ist, ausgebogen sind. Bei allen Elektronikobjekten in der Art von Chipkarten und auch bei zahlreichen Elektronikobjekten mit voluminöseren Objektkörpern sind die ausgebogenen Bereiche der Aussenkontakte der Strukturfolien im allgemeinen über eine oder mehrere Biegungen bzw. Abkröpfungen mit dem Rest der Strukturfolie verbunden, wobei die Aussenkontakte selbst häufig wieder parallel zur Ebene der Strukturfolie angeordnet sind. Zur Herstellung des Objektkörpers wird die Strukturfolie in einen Formhohlraum gebracht und darin so angeordnet und festgehalten, dass sie mit den Aussenkontakten an einer Innenfläche des Formhohlraums anliegt. Anschliessend wird der Kunststoff in den restlichen Raum des Formhohlraums eingespritzt und ggfs. verdichtet und dann das fertige Elektronikobjekt dem Formhohlraum entnommen. In der Aussenfläche des fertigen Elektronikobjektes sind die Aussenkontakte und der den Objektkörper bildende Kunststoff einander benachbart, und es wäre erwünscht, dass die Grenze zwischen jedem Aussenkontakt und dem Kunststoff einer genau definierten Linie, beispielsweise einer Geraden oder einer bestimmten, Kurve folgt. Weist das Elektronikobjekt mehrere Aussenkontakte auf, was im allgemeinen der Fall ist, so sollte nicht nur jede Grenze eines einzelnen Aussenkontaktes einer solchen definierten Linie folgen, sondern sämtliche Grenzen sollten sich auf einer definierten Linie, beispielsweise einer Geraden, einer Kreislinie oder einer anderen geometrisch bestimmten Linie, befinden.

Es hat sich nun herausgestellt, dass es gelegentlich schwierig ist, Elektronikobjekte herzustellen, welche die eben beschriebene Anforderung bezüglich solcher Grenzen zwischen den Aussenkontakten und dem Kunststoff des Objektkörpers erfüllen. Der Grund dafür ist darin zu sehen, dass die Abbiegung bzw. Abkröpfung der Strukturfolie am Übergang zu den Aussenkontakten eine gewisse Abrundung aufweist. Dies kann zur Folge haben, dass beim Spritzen des Objektkörpers der Kunststoff im Bereich der abgerundeten Abbiegung etwa keilförmig und ziemlich zufällig zwischen die Begrenzungsfläche des Formhohlraums und die Strukturfolie dringt, was dann die weitere Folge haben kann, dass im fertigen Kunststoffobjekt die Grenze zwischen dem Kunststoff und den Aussenkontakten nicht wie angestrebt auf einer definierten Linie, beispielsweise einer Geraden oder einer Kreislinie, liegt.

Zwar könnte dies mindestens weitgehend behoben werden, wenn für die Abrundung der Abbiegung der Strukturfolie ein sehr kleiner Biegeradius gewählt würde, doch sprechen verschiedene Gründe gegen die Wahl von solchen kleinen Biegeradien. Erstens besteht bei der Herstellung von Abbiegungen mit kleinen die Gefahr von Rissbildungen in der Strukturfolie selbst. Zweitens haben scharf abgebogene Aussenkontakte die Neigung, sich in der Umgebung der Biegung zu Rinnen zu verformen, welche Rinnen im Querschnitt die Form von flachen U haben; solche Rinnen können sich dann bei der Herstellung des Objektkörpers mit Kunststoff füllen, dies ist bei vollständig im Kunststoff eingebetteten Teilen meistens unwesentlich, kann aber bei den an den Aussenflächen sichtbaren Aussenkontakten eventuell zu optisch unerwünschten, etwa halbmondförmig verlaufenden Grenzen zwischen den Aussenkontakten und dem Kunststoff des Objektkörpers führen, was insbesondere aus ästhetischen Gründen unerwünscht sein kann. Drittens ergeben sich Probleme im Zusammenhang mit der Galvanisierung der Aussenkontakte; da nämlich eine Galvanisierung des Bereiches scharfer Abbiegungen nach der Herstellung der Abbiegungen problematisch sein kann, sollte die Galvanisierung an der noch nicht deformierten Strukturfolie durchgeführt werden; dies bedeutet aber, dass dann nicht nur die Strukturfolie sondern auch die auf ihr durch die Galvanisierung aufgebrachte Schicht gebogen werden muss, wobei in der galvanisierten Schicht kleinere Risse entstehen können; diese Risse beeinträchtigen zwar meistens die elektrische Funktion der Aussenkontakte nicht, bilden aber Zutrittswege zur Strukturfolie, durch welche Fremdstoffe aus der Umgebung dringen können, welche die Strukturfolie angreifen können. Wie oben dargelegt, kann also das Problem der nicht definierten Grenzen zwischen dem Kunststoff des Objektkörpers und den Aussenkontakten durch die Wahl von kleinen Biegeradien für die Biegungen der Strukturfolie nicht optimal behoben werden.

Die Aufgabe der Erfindung wird somit darin gesehen, ein Elektronikobjekt der eingangs genannten Art zu schaffen, an dessen Aussenfläche der Übergang zwischen dem Kunststoff des Objektkörpers und den Aussenkontakten präzis längs einer definierten Linie, beispielsweise einer Geraden, einer Kreislinie oder einer anderen bestimmten Kurve, verläuft.

Diese Aufgabe wird erfindungsgemäss durch die Merkmale des kennzeichnenden Teils des Patentanspruchs 1 gelöst, und vorteilhafte Weiterbildungen des erfindungsgemässen Elektronikobjektes werden durch die abhängigen Patentansprüche **2** bis **8** definiert.

Die Strukturfolie des erfindungsgemässen Elektronikobjektes weist somit im Bereich des Beginns ihrer Wegbiegung von der Aussenfläche des Elektronikobjektes eine Stufe auf. Diese Stufe mit einer längs einer definierten Linie verlaufenden Oberkante herzustellen, ist technisch gut möglich. Die Stufe springt von der dem Äusseren des Elektronikobjektes zugewandten Fläche der Strukturfolie zum Inneren der Strukturfolie zurück. Vom Äusseren des Elektronikobjektes aus gesehen, bildet die Oberkante der Stufe die Grenze zwischen dem Aussenkontakt und dem Kunststoff des Objektkörpers. Der Biegeradius der Abbiegung der Strukturfolie kann nun genügend gross gewählt werden, um die weiter oben beschriebenen Probleme kleiner Biegeradien zu vermeiden. Durch die Stufe in der Strukturfolie erreicht man nämlich, dass sich die Strukturfolie am Beginn der Abbiegung sofort, vorzugsweise unter einem Winkel von mindestens annähernd 90°, von der Aussenfläche des Elektronikobjektes entfernt, so, wie es der Fall wäre, wenn eine herkömmliche Strukturfolie ohne Stufe, jedoch mit einer Abbiegung mit minimalem Biegeradius, verwendet würde. Durch die Stufe erhält man, wie angestrebt, eine definierte Grenze zwischen Aussenkontakten und Kunststoff. Durch die neue Form der Strukturfolie lassen sich sämtliche weiter oben beschriebenen Nachteile herkömmlicher Strukturfolien vermeiden.

Die Linie, auf welcher die Grenze zwischen dem Kunststoff und jedem Aussenkontakt bzw. zwischen dem Kunststoff und benachbarten Aussenkontakten liegt, kann eine Gerade, eine Kreislinie oder eine beliebige andere bestimmte Kurve sein.

Vorzugsweise bildet die rückspringende Stufe die eine Begrenzung einer flächigen Vertiefung der Folie, wobei die andere Begrenzung der Vertiefung durch eine entsprechende vorspringende Stufe gebildet wird. Alternativ könnte der Grund der Vertiefung schief auslaufen.

Die Vertiefung kann sowohl durch eine spanabhebende, galvanische oder laserbewirkte Abtragung oder durch eine Deformation wie beispielsweise eine Prägung der Oberfläche der Strukturfolie erzeugt werden. Die Vertiefung kann vor oder nach der Biegung der Strukturfolie erzeugt werden; mit einer Erzeugung der Vertiefung vor der Biegung erzielt man einen zusätzlichen Vorteil, nämlich eine infolge der verminderten Wandstärke bessere Biegbarkeit der Strukturfolie.

Die Stufe kann auch dadurch erzeugt werden, dass eine Strukturfolie verwendet wird, welche aus zwei miteinander verbundenen Folienteilen mit unterschiedlichen Wandstärken verwendet wird, wobei der Folienteil mit der grösseren Wandstärke die Aussenkontakte und der Folienteil mit der kleineren Wandstärke den ins Innere des Elektronikobjektes abgebogenen Bereich der Strukturfolie bildet; die Strukturfolie kommt dabei während des Spritzens des Objektkörpers so in den Formhohlraum bzw. später in das Elektronikobjekt zu liegen, dass der Übergang zwischen den Folienteilen die Stufenoberkante der rückspringenden Stufe bildet.

Das Elektronikobjekt kann auch so ausgebildet sein, dass es mindestens einen weiteren Aussenkontakt besitzt, der seriell mit dem mindestens einen erstgenannten Aussenkontakt angeordnet und beidseitig über weitere Biegungen mit dem Rest der Strukturfolie verbunden ist. Die Strukturfolie kann dann so geformt sein, dass sie im Bereich jeder Biegung eine weitere rückspringende Stufe aufweist, die so ausgebildet und angeordnet ist, wie die weiter oben beschriebene Stufe.

Elektronikobjekte mit mehreren seriell angeordneten Aussenkontakten sind vorzugsweise so ausgebildet, dass diese Aussenkontakte in verschiedenen Aussenflächen des Elektronkelementes angeordnet sind.

Die Aussenflächen des Elektronikobjektes bzw. die darin angeordneten Aussenkontakte können eben, einfach oder mehrfach gekrümmt sein.

Ein weiteres Problem bei der Herstellung von Elektronikobjekten steht im Zusammenhang mit der Bestückung der Strukturfolien mit Elektronikelementen. Um beispielsweise Halbleiterchips auf der Strukturfolie zu befestigen, wird auf eine Chipinsel der Strukturfolie eine klebende Schicht, beispielsweise ein Tropfen eines Klebers, aufgebracht. Auf diese klebende Schicht wird anschliessend der Halbleiterchip gebracht. Schliesslich wird der mit seiner Unterseite auf der Strukturfolie haftende Halbleiterchip seitlich und oben durch eine Kunststoffkapsel umkapselt, welche aus einem Kunststoff hergestellt wird, der in fliessfähiger Form zugebracht wird und anschliessend erhärtet. Die auf diese Weise hergestellte Kunststoffkapsel tritt dabei an die Stelle des früher üblichen, durch ein Spritz- oder Giessverfahren in einer Form hergestellten Kunststoffgehäuses, mit welchem der Halbleiterchip umspritzt bzw. umgossen wurde. Die Herstellung einer solchen Kunststoffkapsel, für welche keine Form benötigt wird, ist offensichtlich einfacher und rationeller als die Herstellung des in einer Form gespritzten bzw. gegossenen Kunststoffgehäuses, doch besteht dabei die Gefahr, dass der in fliessfähiger Form zugebrachte Kunststoff nicht genügend rasch aushärtet bzw. bei zu geringer Viskosität seitlich wegfliesst, so dass keine einwandfreie Kunststoffkapsel entsteht. Um dies zu verhindern, wurde versucht, vor der Herstellung der Kunststoffkapsel auf der Strukturfolie eine Art Erhöhung bzw. Damm aus einem anderen Kunststoff anzubringen, welcher eine sehr hohe Viskosität aufweist und/oder sehr rasch aushärtet. Der Nachteil einer auf diese Weise erzeugten Erhöhung ist darin zu sehen, dass ihre Herstellung wegen des zusätzlich benötigten Kunststoffes verhältnismässig aufwendig ist.

Es ist daher eine weitere Aufgabe der Erfindung, ein Elektronikobjekt zu schaffen, bei welchem die Erhöhung zur Begrenzung der das Elektronikelement umgebenden Kunststoffkapsel in einfacher Weise hergestellt ist.

Diese weitere Aufgabe wird erfindungsgemäss durch die Merkmale des kennzeichnenden Teils des Patentanspruchs **9** gelöst, und eine vorteilhafte Weiterbildung der Erfindung ist durch den Patentanspruch **10** definiert.

Die Erhöhung, durch welche die Ausbreitung des fliessfähigen Kunststoffes und schliesslich die Kunststoffkapsel selbst begrenzt ist, besteht erfindungsgemäss aus einer Stufe, zu welcher ein entsprechende Bereich, beispielsweise ein Ringbereich, der Strukturfolie verformt ist, welcher diejenige Fläche der Strukturfolie umgibt, auf der Halbleiterchip oder ggfs. ein anderes Elektronikelementes befestigt ist; die Stufenunterkante liegt dabei in der Höhe der Fläche, auf der das Elektronikelement befestigt ist, so dass sich dieses in einer Vertiefung befindet.

Die Vertiefung kann in gleicher Weise, nämlich durch ein materialabtragendes oder materialdeformierendes Verfahren, hergestellt sein wie die weiter oben beschriebene Vertiefung im Bereich der Aussenkontakte der Strukturfolie.

Im folgenden wird die Erfindung anhand von Ausführungsbeispielen ausführlich beschrieben. Es zeigen
- **Fig. 1A**: ein erstes in einem Formhohlraum angeordnetes Elektronikobjekt nach dem Stand der Technik, nach dem Spritzen des den Objektkörper bildenden Kunststoffes, mit einer Strukturfolie, die Abbiegungen mit einem grossen Biegeradius aufweist, ausschnittweise, in einem Schnitt;
- **Fig. 1B**: das in Fig. 1A dargestellte Elektronikobjekt, in einer Ansicht seiner Frontseite;
- **Fig. 2A**: ein zweites Elektronikobjekt nach dem Stand der Technik, mit einer Strukturfolie, die Abbiegungen mit einem kleinen Biegeradius aufweist, in gleicher Darstellung wie Fig. 1A;
- **Fig. 2B**: das in Fig. 2A dargestellte Elektronikobjekt, in gleicher Darstellung wie Fig. 1B;
- **Fig. 2C**: das in den Fig. 2A und 2B dargestellte Elektronikobjekt, in einem Schnitt längs der Linie II - II der Fig. 2A;
- **Fig. 3A**: ein erstes Elektronikobjekt nach der Erfindung, in gleicher Darstellung wie die Fig. 1A und 2A;
- **Fig. 3B**: das in Fig. 3A dargestellte Elektronikobjekt, in gleicher Darstellung wie die Fig. 1B und 2B;
- **Fig. 4**: ein drittes Elektronikobjekt nach der Erfindung, wobei die Stufe am Übergang zwischen durch Strukturfolienteile mit unterschiedlichen Wandstärken gebildet wird, in gleicher Darstellung wie die Fig. 1A, 2A und 3A;
- **Fig. 5**: ein viertes Elektronikobjekt nach der Erfindung, wobei die Grenze zwischen dem Kunststoff und den Aussenkontakten auf einer Kreislinie liegt, in gleicher Darstellung wie Fig. 3A;
- **Fig.6**: ein fünftes Elektronikobjekt nach der Erfindung, mit einem weiteren, seriell zum erstgenannten Aussenkontakt angeordneten Aussenkontakt, in gleicher Darstellung wie die Fig. 3A und 4;
- **Fig.7**: ein sechstes Elektronikobjekt nach der Erfindung, mit insgesamt drei Aussenkontakten, in gleicher Darstellung wie die Fig. 3A, 4 und 6;
- **Fig.8**: ein siebtes Elektronikobjekt nach der Erfindung, mit einem zylindrischen Objektkörper, ausschnittweise, in einem Schnitt quer zu seiner Längsachse;
- **Fig.9**: eine Strukturfolie mit einem auf ihr befestigten und von einer Kunststoffkapsel umgebenen, in einer Vertiefung angeordnetem Halbleiterchip, ausschnittweise, in einem Schnitt; und
- **Fig.10**: eine Strukturfolie mit einem auf ihr befestigten und von einer Kunststoffkapsel umgebenen, in einer Vertiefung angeordneten Halbleiterchip, ausschnittweise, in einem Schnitt, wobei die Vertiefung durch Entfernung einer Schicht der zweischichtigen Strukturfolie gebildet ist, in gleicher Darstellung wie Fig. 9.

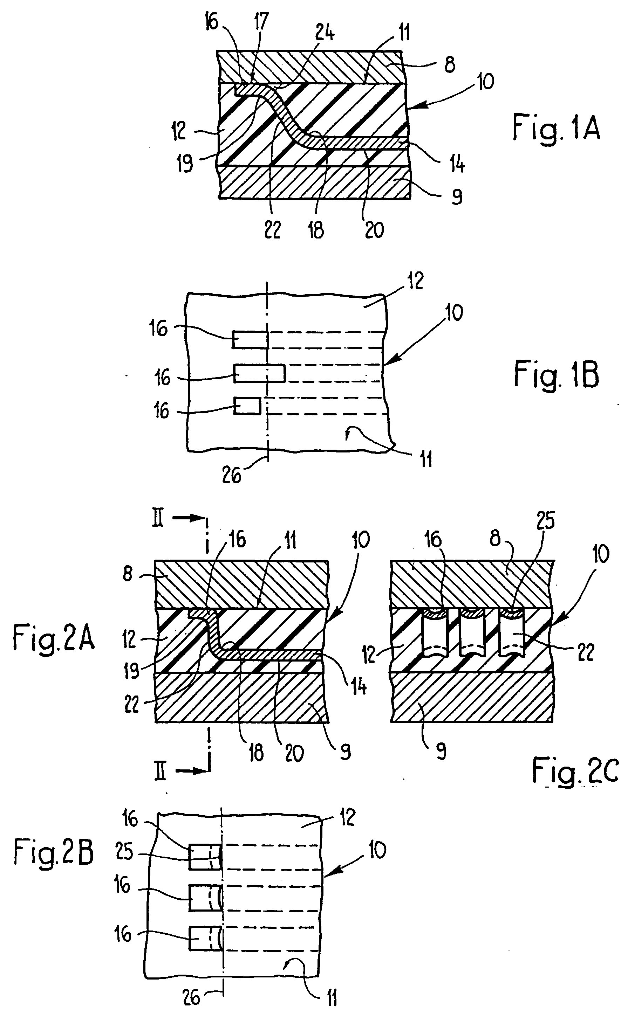

**Fig.1** zeigt ein in einem Formhohlraum, der durch zwei Formteile **8, 9** begrenzt ist, befindliches Elektronikobjekt **10** nach dem Stand der Technik. Das Elektronikobjekt **10** weist einen Objektkörper **12** und eine Strukturfolie **14** auf. Die Strukturfolie **14** liegt im wesentlichen parallel zum Objektkörper **12** des verhältnismässig dünnen Elektronikobjektes **10** und weist einen Randbereich auf, an welchem durch parallel zur Zeichenebene verlaufende, in **Fig. 1** nicht sichtbare Schlitze mehrere Aussenkontakte **16** gebildet sind, von welchen **Fig. 1B** drei Aussenkontakte **16** zeigt. Jeder Aussenkontakt **16** ist durch eine erste Biegung **18** und eine zweite Biegung **19** aus der Ebene des mittigen Bereiches **20** der Strukturfolie **14** ausgebogen. Durch die Biegungen **18** und **19** werden eine Art Steg **22** und der Aussenkontakt **16** gebildet, wobei der Steg **22** quer und der Aussenkontakt **16** parallel zum mittigen Bereich **20** der Strukturfolie **14** verlaufen. Die Biegungen **18** und **19** weisen verhältnismässig grosse Biegungsradien auf, und der Kunststoff des Objektkörpers **12** bildet zwischen dem Formteil **8** und den Aussenkontakten **16** eine Art Keil **24**. An der Aussenfläche **11** des Elektronikobjektes **10**, die in **Fig. 1B** sichtbar ist, sind die drei bündig mit dieser Aussenfläche **11** liegenden Aussenkontakte **16** bzw. deren dem Äusseren des Elektronikobjektes zugewandten Flächen **17** sichtbar. Infolge der unterschiedlichen Formen und Abmessungen der Keile **24** liegen die Grenzen zwischen den Aussenkontakten **16** und dem Kunststoff des Objektkörpers **12** nicht, wie es eigentlich erwünscht wäre, auf einer Geraden **26**.

Die **Fig. 2A, 2B** und **2C** zeigen ebenfalls ein Elektronikmodul **10** nach dem Stand der Technik, im wesentlichen gleich aufgebaut wie das in den **Fig. 1A** und **1B** dargestellte Elektronikmodul, jedoch mit dem Unterschied, dass die Biegungen **18** und **19** verhältnismässig kleine Biegungsradien aufweisen. Dadurch vermeidet man zwar weitgehend die Bildung der Keile **24**, dafür entstehen durch den Biegevorgang U-förmige rillenartige Deformationen **25** gemäss **Fig. 2C** im Bereich der Biegungen **18** und **19**, welche sich bei der Herstellung des Objektkörpers **12** mit Kunststoff füllen. Dies hat gemäss **Fig. 2B** zur Folge, dass bei solchen Elektronikobjekten **10** zwar die Grenzen zwischen den einzelnen Aussenkontakten **16** und dem Kunststoff des Objektkörpers **12** nicht wesentlich gegeneinander versetzt sind, dass aber die Grenze jedes Aussenkontaktes **16** etwa halbmondähnlich verläuft, weil der Kunststoff die U-förmigen rillenartigen Deformationen **25** füllt.

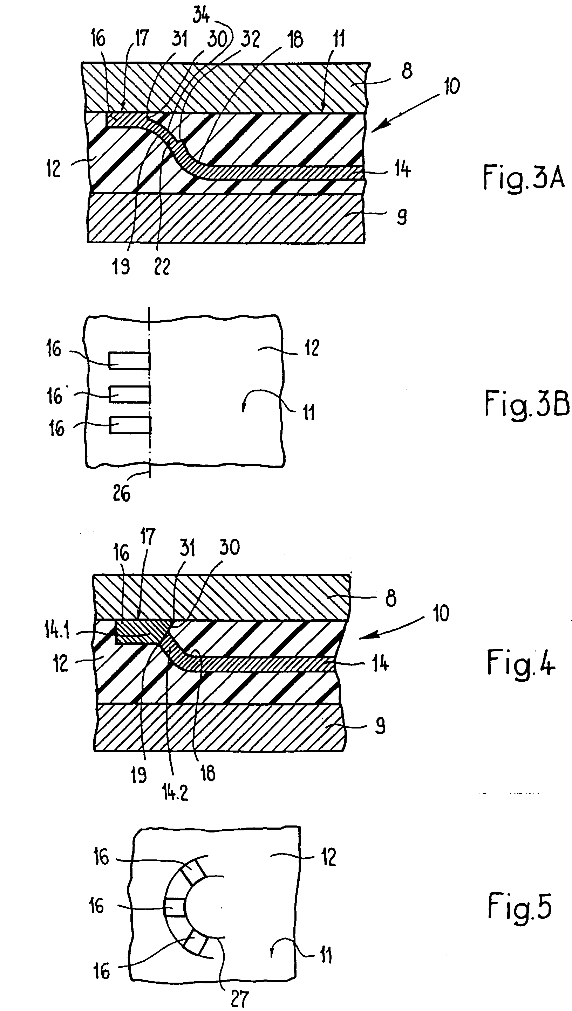

**Fig 3A** zeigt ein Elektronikmodul **10** nach der Erfindung, mit einer Strukturfolie **14**, welche im Bereich der Biegung **19,** die an die Aussenkontakte **16** angrenzt, an ihrer dem Äusseren des Elektronikobjektes **10** zugewandten Fläche **17** eine rückspringende Stufe **30** aufweist. Diese Stufe **30** begrenzt zusammen mit einer weiteren, vorspringenden Stufe **32** im stegartigen Teil **22** der Strukturfolie **14** eine flächige Vertiefung **34** in der Strukturfolie **14**, durch welche die Wandstärke der Strukturfolie **14** örtlich verringert wird. Die Stufe **30** hat zur Folge, dass sich die Strukturfolie **14** praktisch unter einem rechten Winkel vom Formteil **8** entfernt, wobei die Stufenoberkante **31** eine genau definierte Begrenzung für den Kunststoff des Objektkörpers **12** bildet, so dass an der Aussenfläche des fertigen Elektronikobjektes **10** die Grenze zwischen dem Kunststoff und den Aussenkontakten **16** auf die Gerade **26** zu liegen kommt, wie dies aus **Fig. 3B** ersichtlich ist.

**Fig. 4** zeigt ein weiteres Elektronikobjekt **10** nach der Erfindung, das ähnlich ausgebildet ist wie das Elektronikobjekt der **Fig. 3A** und **3B**. Im Unterschied zur Strukturfolie **14** des Elektronikobjektes **10** gemäss **Fig. 3A** und **3B,** deren Wandstärke überall gleich ist, weist aber das Elektronikobjekt **10** gemäss **Fig. 4** eine Strukturfolie **14** auf, die aus zwei miteinander verbundenen Folienteilen **14.1** und **14.2** besteht. Die Aussenkontakte **16** sind aus dem Folienteil **14.1** gebildet; wobei die Wandstärke des Folienteils **14.1** grösser ist als die Wandstärke des Folienteils **14.2.** Die Strukturfolie **14** wird in diesem Fall so im Formhohlraum bzw. im fertigen Elektronikobjekt **10** angeordnet, dass die Stufe **30** durch den Übergang vom Folienteil **14.1** zum Folienteil **14.2** gebildet wird. Die Draufsicht auf das Elektronikobjekt **11** gemäss **Fig. 4** ist dieselbe wie die in **Fig. 3B** dargestellte Draufsicht auf das Elektronikobjekt gemäss **Fig. 3A**:

In **Fig. 5** ist ein weiteres Elektronikobjekt **10** dargestellt, dessen Aussenkontakte **16** in einem Kreisring liegen bzw. im Bereich ihrer Biegung durch einen Kreis **27** begrenzt sind.

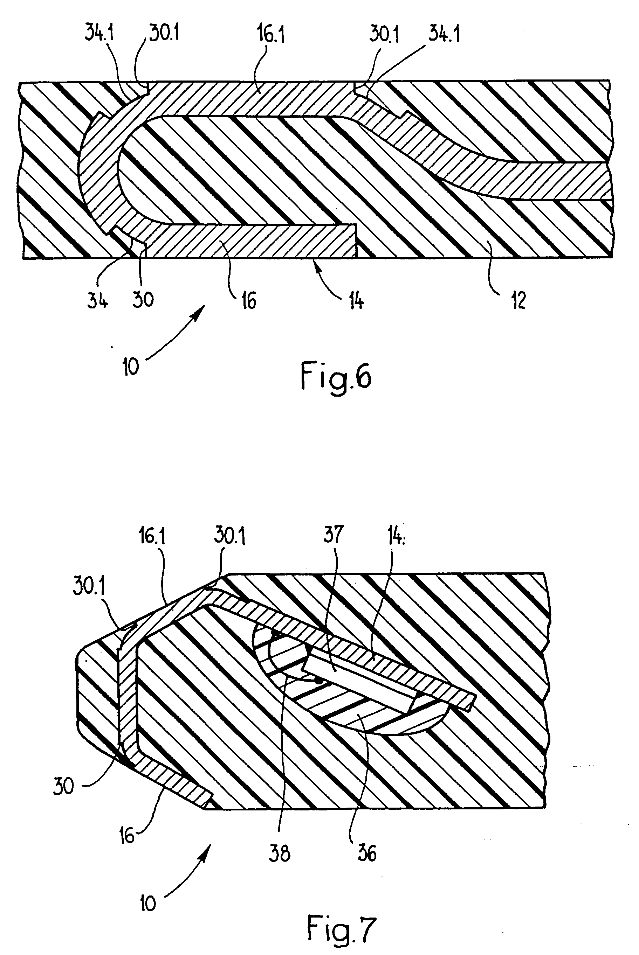

**Fig. 6** zeigt ein Elektronikobjekt **10,** das eine Strukturfolie **14** enthält, die so geformt ist, dass sie zusätzlich zum Aussenkontakt **16** einen weiteren Aussenkontakt **16.1** aufweist, wobei die beiden Aussenkontakte **16, 16.1** an zwei gegenüberliegenden, einander parallelen Aussenflächen des Elektronikobjektes **10** angeordnet sind. Die Strukturfolie **14** weist angrenzend an den Aussenkontakt **16** die Stufe **30** bzw. die Vertiefung **34** und angrenzend an den Aussenkontakt **16.1** zwei Stufen **30.1** bzw. zwei Vertiefungen **34.1** auf. Das äussere Ende der Strukturfolie **14** ist scharfkantig, so dass auch dort eine einwandfreie Grenze zwischen dem Kunststoff des Objektkörpers **12** und jedem Aussenkontakt **16** entsteht.

Das in **Fig. 7** dargestellte Elektronikobjekt **10** ist, im Gegensatz zu den chipkartenförmigen, flachen Elektronikobjekten der **Fig. 3A** bis **5**, ein voluminöseres Elektronikobjekt. Es weist eine Strukturfolie **14** auf, die ebenfalls Aussenkontakte **16, 16.1** an zwei Aussenflächen des Elektronikelementes **10** bildet, wobei diese Aussenflächen nicht parallel sondern unter einem gegenseitigen Winkel angeordnet sind. **In Fig. 7** ist auch ein an der Strukturfolie **14** fixierter, von einer Kunststoffkapsel **36** umgebener Halbleiterchip **37** mit seiner Kontakterung **38** abgebildet. Die Stufen **30, 30.1** bzw. die Vertiefungen **34, 34.1** sind entsprechend den Stufen und Vertiefungen gemäss **Fig. 6** ausgebildet und angeordnet.

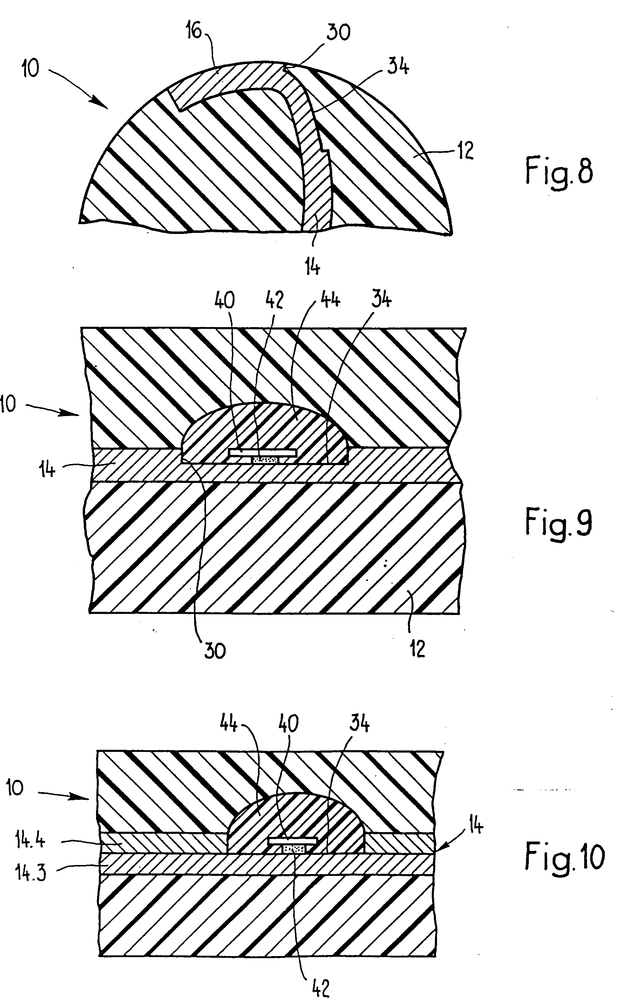

In **Fig. 8** ist ein zylindrisches Elektronikobjekt **10** gezeigt, dessen Aussenkontakte **16** in Umfangsrichtung verlaufen und damit einfach gekrümmte Flächen bilden. Die Stufen **30** sind hier so angeordnet, dass sie annähernd radial ins Innere des Elektronikobjektes **10** zurückspringen. Grundsätzlich können auch Aussenkontakte **16** mit mehrfach gekrümmten Flächen mit Stufen ausgebildet werden.

Das Prinzip der Erzeugung der einer definierten Linie folgenden Grenze für fliessfähig zugebrachten Kunststoff mit Hilfe von Stufen in der Strukturfolie lässt sich bei Elektronikobjekten **10** bzw. Strukturfolien **14** grundsätzlich überall anwenden. Als Beispiel zeigt **Fig. 9** eine Strukturfolie **14** eines weiteren Elektronikobjektes **10** mit einem Objektkörper **12,** wobei die Strukturfolie **14** mit einem Halbleiterchip **40** bestückt ist. Der Halbleiterchip **40** ist mittels einer klebenden Schicht **42** auf der Strükturfolie **14** befestigt und von einer Kunststoffkapsel **44** umgeben. Die Strukturfolie **14** weist im Bereich der Kunststoffkapsel **44** eine Vertiefung **34** auf, die von einer Stufe **30** begrenzt ist, welche gleichzeitig die Begrenzung der Kunststoffkapsel **44** bildet.

**Fig. 10** zeigt eine Strukturfolie **14**, welche der in **Fig. 9** dargestellten Sttukturfolie ähnlich ist, mit dem einzigen Unterschied, dass die Strukturfolie **14** hier aus zwei Schichten **14.3, 14.4** gebildet ist, und dass die Vertiefung **34** durch lokale Entfernung der Schicht **14.4** erzeugt ist.

## Patentansprüche

1. Elektronikobjekt (**10**), umfassend
- eine Strukturfolie (**14**) und
- einen Objektkörper (**12**) aus gespritztem Kunststoff, mit welchem die Strukturfolie (**14**) verbunden ist,
- wobei die Strukturfolie (**14**) mindestens einen über mindestens eine Abbiegung (**19**) mit ihrem Zentralbereich (**20**) verbundenen Bereich besitzt, der einen Aussenkontakt (**16**) bildet, welcher bündig mit dem Objektkörper (**12**) in einer Aussenfläche (**11**) des Elektronikobjektes (**10**) liegt,
**dadurch gekennzeichnet,**
dass die Strukturfolie (**14**) im Bereich der Abbiegung (**19**) auf ihrer dem Äusseren des Elektronikobjektes (**10**) zugewandten Fläche (**17**) eine von der genannten Fläche (**17**) zurückspringende Stufe (**30**) aufweist, deren Stufenoberkante (**31**) in der genannten Fläche (**17**) eine Grenze für den Kunststoff des Objektkörpers (**12**) bildet.

2. Elektronikobjekt nach Patentanspruch **1,**
**dadurch gekennzeichnet,**
dass die genannten Grenze jedes Aussenkontaktes (**16**) bzw. die Grenzen mehrerer benachbarter Aussenkontakte (**16**) auf einer definierte Linie, beispielsweise einer Geraden (**26**), einer Kreislinie (**27**) oder einer anderen bestimmten Kurve, liegen.

3. Elektronikobjekt (**10**) nach mindestens einem der Patentansprüche **1** bis **2,**
**dadurch gekennzeichnet,**
dass die Strukturfolie (**14**) eine Vertiefung (**34**) aufweist, die einerseits durch die rückspringenden Stufe (**30**) und vorzugsweise anderseits durch eine im Abstand von der rückspringenden Stufe (**30**) angeordnete vorspringende Stufe (**32**) begrenzt ist.

4. Elektronikobjekt (**10**) nach Patentanspruch **3,**
**dadurch gekennzeichnet,**
dass die Vertiefung (**34**) durch eine materialabtragende oder materialdeformierende Bearbeitung erzeugt ist.

5. Elektronikobjekt (**10**) nach mindestens einem der Patentansprüche **1** bis **2,**
**dadurch gekennzeichnet,**
dass die Strukturfolie (**14**) aus zwei miteinander verbundenen Folienteilen (**14.1, 14.2**) gebildet ist, die unterschiedliche Wandstärken aufweisen, wobei die Folienteile (**14.1, 14.2**) so angeordnet sind, dass die rückspringende Stufe (**30**) beim Übergang vom Folienteil (**14.1**) grösserer Wandstärke zum Folienteil (**14.2**) geringerer Wandstärke gebildet ist.

6. Elektronikobjekt (**10**) nach mindestens einem der obigen Patentansprüche,
**dadurch gekennzeichnet,**
dass es mindestens einen weiteren, seriell mit dem mindestens einen Aussenkontakt (**16**) angeordneten Aussenkontakt (**16.1**) aufweist, der vorzugsweise in einer weiteren Aussenfläche des Elektronikobjektes (**10**) liegt und über weitere Biegungen (**19.1**) mit dem Rest der Strukturfolie (**14**) verbunden ist, wobei die Strukturfolie (**14**) im Bereich jeder der weiteren Biegung (**19.1**) eine weitere Stufe (**30.1**) aufweist.

7. Elektronikobjekt (**10**) nach mindestens einem der obigen Patentansprüche,
**dadurch gekennzeichnet,**
dass die Aussenkontakte (**16**) ebene oder ein- oder mehrfach gekrümmte Flächen bilden.

8. Elektronikobjekt (**10**) nach mindestens einem der obigen Patentansprüche,
**dadurch gekennzeichnet,**
dass die Aussenkontakte (**16, 16.1**) in verschiedenen Aussenflächen des Elektronikobjektes (**10**) angeordnet sind.

9. Elektronikobjekt (**10**) mit einer Strukturfolie (**16**), auf welcher ein Elektronkelement (**40**) befestigt ist, das oben und seitlich von einer aus in fliessfähigem Zustand zugebrachten, erhärtetem Kunststoff bestehenden Kunststoffkapsel (**44**) umgeben ist, die auf einer durch eine vorspringende Erhöhung begrenzten Fläche der Strukturfolie (**14**) angeordnet ist,
**dadurch gekennzeichnet,**
dass die Erhöhung eine in der Strukturfolie (**14**) gebildete Stufe (**30**) ist, welche eine Vertiefung (**34**) der Strukturfolie (**14**) umgibt.

10. Elektronikobjekt (**10**) nach Patentanspruch **9,**
**dadurch gekennzeichnet,**
dass die Vertiefung (**34**) durch eine materialabtragende oder materialdeformierende Bearbeitung erzeugt ist.
